# EUROPEAN PATENT SPECIFICATION

(11) **EP 0 618 620 B1**
(45) Date of publication and mention of the grant of the patent: **24.11.1999**
(21) Application number: 94302043.8
(22) Date of filing: 22.03.1994
(51) Int. Cl.: H01L 23/525

(54) **Semiconductor fuse structures**
Halbleiter-Schmelzsicherungstrukturen
Structures fusibles d'un semi-conducteur

(30) Priority: 01.04.1993 US 41677
(43) Date of publication of application: 05.10.1994
(73) Proprietor: ADVANCED MICRO DEVICES INC., Sunnyvale, California 94088-3453 (US)
(72) Inventor: Grams, Michael L., Austin, Texas 78748 (US); Achee, Ehren T., Austin, Texas 78741 (US)
(74) Representative: BROOKES & MARTIN

(56) References cited:
- DE-A- 2 625 089
- DE-A- 3 617 141
- US-A- 4 209 894
- PATENT ABSTRACTS OF JAPAN vol. 9, no. 230 (E-343)17 September 1985 & JP-A-60 084 837 (HITACHI SEISAKUSHO KK)

## Description

This invention relates to an integrated circuit and more particularly to an electrically programmable fuse structure.

Integrated circuits are generally fabricated from a wafer of silicon through a number of processing steps, including photomasking, etching and diffusion, in order to create a pattern of junctions and interconnections along the surface of the wafer. One of the final steps in the manufacturing process is to coat the entire surface with a metallization layer and then to selectively etch away portions of the metallization, leaving the desired interconnecting pattern. As defined herein, "metallization" includes any conductive layer such as aluminum, polycrystalline silicon, etc., which can be formed into an interconnecting pattern and routed between active regions within the wafer. In some instances, the user requires the interconnecting pattern to be altered depending upon a target application. If such is the case, the wafer may be processed through the point of metallization and held in storage until the target data pattern is defined. Once the pattern is defined, a mask is then produced having the necessary pattern, and the final pattern is photoprocessed and etched from the metallization via the masking pattern to produce the user-specific wafer or circuit. The above process is generally described as mask programmable process or technique and is advantageous in reducing lead time required for fabrication of user-specific circuits.

Another technique often used to produce user-specific circuits is to produce the wafer with all internal connections in tact during the manufacturing process. The desired data pattern is then defined after final packaging rather than when the device is manufactured. The user can "program" the circuit by applying electrical input to certain select interconnect within the circuit in order to customize the interconnect by "blowing" or disconnecting them. Field-programmable, or electrically programmable circuits are achieved using programmable links or fuses.

As defined herein, "link", "fuse" or "fuse structure" is a thin conductive structure generally arranged as a filament which can be broken at select locations by applying a measured programmable voltage across the filament and/or current through the filament. Accordingly, a fuse structure can be deposited at select programmable areas across the wafer topography using typical thin film deposition of metallization and subsequent etching techniques to produce a relatively narrow conductive structure at all potential programmable areas. Depending upon the user-defined application, the fuse structure can be either blown or unblown in the field to achieve the target circuit outcome.

Electrically programmable read only memory (PROM) generally employs a plurality of fuse structures which can be blown or unblown to represent a digital bit pattern of ones and zeros signifying data which the user wishes to store within the PROM array. Not limited to only PROMs, fuse structures may also be found in any type of user-programmable device. For example, fuse structures may be used to activate or deactivate one or more specific circuits within a generic programmable device. One way in which to do so is to fabricate the device with all circuits connected via conductive fuses and then deactivate select circuits by blowing corresponding fuses in the field. User-programmable devices may include any user programmable analog or digital circuit such as a gate array, which includes application specific integrated circuits (ASICs), custom-designed circuits (ICSs), standard cells and programmable logic devices (PLDs). Devices which utilize fuse structures can be fabricated in metal oxide semiconductor (MOS), emitter-coupled logic (ECL), transistor-transistor logic (TTL), gallium arsenide, silicon-on-sapphire, and various combinations of these technologies.

Early fuse structures were generally made with an alloy of nickel and chrome (nichrome) deposited as a very thin film linking adjacent interconnect lines. Heavy current, often exceeding 50 mA, is sent through the nichrome fuse causing the fuse to blow open. For example, a blown fuse coupled to the source or drain (MOS), or the emitter or collector (TTL), may cause a logic one to appear in a PROM memory array bit line. Conversely, if the fuse is not blown, then a logic zero appears in the addressed column or bit line.

Nichrome fuse structures often suffer from several shortcomings. First, nichrome can be difficult to apply within the constraints of thin film deposition, especially considering the extremely thin layer (generally less than 200 angstroms) which must be deposited in order to achieve the desired fuse resistance. In order to blow at 50 mA, assuming 5 V TTL or MOS level, the nichrome material must generally not exceed 200 angstroms in thickness. If the fuse structure is thicker than 200 angstroms or is wider than, for example, a couple microns, the structure may not reliably program when desired. A second problem associated with nichrome fuse structures, and probably the most serious problem, is the phenomena commonly referred to as "growback". Growback is defined as the reversal of the programming process such that a fuse will, after some time, reconnect after it has been blown, or go from a programmed state back to an unprogrammed state.

Considerable time and effort has been spent investigating growback in fuse structures to understand how the fuse blows, to determine the location and movement of conductive fuse material before and after diffusion, and to learn why a small number of fuses, once blown, appear to reconnect. Studies indicate that growback may occur for two reasons. First, the blown fuse may growback together because of some form of crystal regrowth occurring in the blown area. Second, a fuse structure might appear reconnected when in fact the structure was not completely blown to begin with. Instead the structure was only partially opened to form a high impedance short. The presence of growback poses a considerable reliability problem in user-defined circuits such as, for example, PROMs.

In an effort to reduce failure via growback, it becomes important to ensure the fuse is completely blown and that a high impedance short does not exist. To provide a complete open, the programming energy is generally quickly ramped upward so that the fuse blows on a fast rise time. Fast adiabatic fusing results in a wider gap or separation in the blown area. However, due to slight fluctuations in the fuse geometry, even high rise time programming current may still leave certain fuse areas with intermittent fingers or dendrites extending across the supposedly open area, relinking or reconnecting the fuse after a certain period of time has elapsed. The reconnected fuse brought about by growback thereby appears after a period of time even in cleanly blown fuses.

In an effort to minimize or eliminate regrowth, other fusing materials besides nichrome have been used including aluminum, polycrystalline silicon, tungsten titanium, etc. An advantage of polycrystalline silicon or polysilicon fuse material is that the polysilicon fuse can be made much thicker than nichrome and resistivity can be more accurately controlled by doping of the fuse during the doping of the adjacent integrated circuit. Programming of the polysilicon fuse occurs by melting the fuse with a successive pulse train of current. During the programming or blowing operation, temperatures exceeding 1000°C or 1400°C may occur in the fuse area. Due to the high temperature melting operation necessary to blow a polysilicon fuse, windows are typically etched through the passivation glass over each fuse to allow freedom for the molten polysilicon to roll apart and thicken where it is blown.

Although polysilicon fuses are less susceptible to growback than are nichrome fuses, growback still remains. Absent windows, polysilicon fuses do not separate well and in some instances may not separate at all. The fuse area thereby remains susceptible to growback and associated electromigration.

JP-A-60 084 837 and the corresponding abstract (Patent Abstracts of Japan, vol 9, no 230, E-343, 17/9/85) discloses a semiconductor integrated circuit device with a fuse with a relatively narrow cutting part in the centre. This central cutting part is arranged over a projection consisting of an insulator and the layers over the fuse are arranged to leave an aperture above the fuse. The purpose of the projection in the underlying insulating film is to prevent reconduction of the fuse.

DE-A-2 625 089 (and corresponding US patent 4,267,633) describes a method of making an integrated circuit with a severable conductive strip. Again the region of insulating material beneath the zone which is to be severed is increased in thickness, preferably in stepped form, so that the heat capacity at the point of severing the conductor is less than the heat dissipation at other regions of the conductor. The conductor is severed by applying probes at contact points by means of which a current can be passed through the conductor. The contact points on the conductor directly abutt doped regions of the semiconductor substrate surface.

DE-A-3 617 141 (and corresponding US patent 4,774,561) describe a fusible link designed to be severed by melting with a laser beam. The fusible link is arranged to cross a stepped region of an underlying insulating layer, the stepped region being provided by an underlying polysilicon gate. The fuse is melted over the entire width of the stepped region, providing a length of interruption which is tolerant with respect to variations in the positional accuracy and radius of the laser beam.

The United States patent No. 4,209,894 describes a fusible-link programmable read only memory employing a deposit of metal film as a fuse. In order to minimise heat loss to the semiconductor substrate when programming and to provide a cavity beneath the protective glaze sealing the chip, the metal film is raised above the surface of the underlying silicon oxide at the position of the fusible link. This is accomplished using a segment of photoresist applied prior to metal deposition, afterwards removed with photoresist stripper.

The problems outlined above are in large part solved by the electrically programmable fuse structure described herein. In particular, the fuse structure has a raised insulating layer placed below the fusing element or filament. The underlayer provides a bump or protrusion (i.e. step) extending substantially perpendicular to the fuse path and also extending from the substrate surface over which the filament extends. The filament is manufactured according to normal thin film deposition, lithography and etching techniques associated with normal processing of an integrated circuit embodying the fuse structure.

The underlying bump or protrusion (i.e. step) ensures that the filament is formed in an elongated arcuate path, and when the filament is blown, the separated ends of the filament will not reconnect or regrow upward along the arcuate path toward one another. Essentially, the protruding underlayer ensures that when the fuse is blown, fuse particles will project outward in a direction substantially normal to the raised underlayer and away from the fuse area. Outward projected particles are thereby less likely to fall back into the fuse area. The protruding underlayer or step, with arcuate sidewalls and/or arcuate upper surface, provides an arcuate path for the overlying filament that, when blown, directs fuse particles away from the fuse area and further prevents the fuse particles from migrating up the arcuate, protruding area and back into the opened fuse area after the fuse is blown.

Accordingly, it is postulated that any type of fusing material can be used for the filament and fuse structure hereof. Popular types of materials used in integrated circuit fabrication are preferred. Exotic types of fusing materials are not needed in order to prevent regrowth. Conventional materials placed over an easily formed, normally processed, raised underlayer is all that is needed to substantially prevent regrowth.

An improved fuse structure comprising an arcuate fuse filament with the addition of a perpendicularly extending, insulating underlayer or step is configured below the center of the filament. A polysilicon fuse for this structure would require that the fabrication process be at least a dual polysilicon process to allow for the perpendicular structure. Various design schemes can be used to illustrate the objective of the fuse structure to create worst-case step coverage of the filament over the underlying insulating structure. Worst-case step coverage will localize and optimize the fuse blowing mechanism and provide a physical barrier to prevent regrowth of the blown area.

According to the present invention, there is provided an electromigration-resistant, electrically programmable fuse structure as defined in claim 1.

The first insulating layer may comprise silicon dioxide, and the second insulating layer may comprise silicon dioxide. The metallization region may comprise polycrystalline silicon and/or a metal. Preferably, the second upper surface is configured to extend a length L and a width W. The filament is configured to extend across width W substantially perpendicular to length L, and the filament includes a width which is less than length L. Further features are defined in the dependent claims.

Other objects and advantages of the invention will become apparent upon reading the following detailed description and upon reference to the accompanying drawings in which, by way of example only:
Fig. 1 is a top plan view of a fuse structure not forming a part of the present invention;
Fig. 2 is a cross-sectional view along plane A-A of the fuse structure shown in Fig. 1 including a thickened insulating layer placed beneath an interconnect having one end connected to a diffusion region;
Fig. 3 is a cross-sectional view along plane A-A of the fuse structure shown in Fig. 1 including an insulating layer raised above a metallization layer, wherein the raised insulating layer is placed beneath an interconnect having one end connected to a diffusion region;
Fig. 4 is a top plan view of a fuse structure embodying the present invention;
Fig. 5 is a cross-sectional view along path A-A of the fuse structure shown in Fig. 4 connected to a diffusion region.
Fig. 6 is a circuit diagram showing an application of the electrically programmable fuse structure placed within a single memory cell;
Fig. 7 is a circuit diagram showing an alternative application of the electrically programmable fuse structure placed within a single memory cell; and
Fig. 8 is a circuit diagram showing a second alternative application of the electrically programmable fuse structure arranged in a memory array of structures.

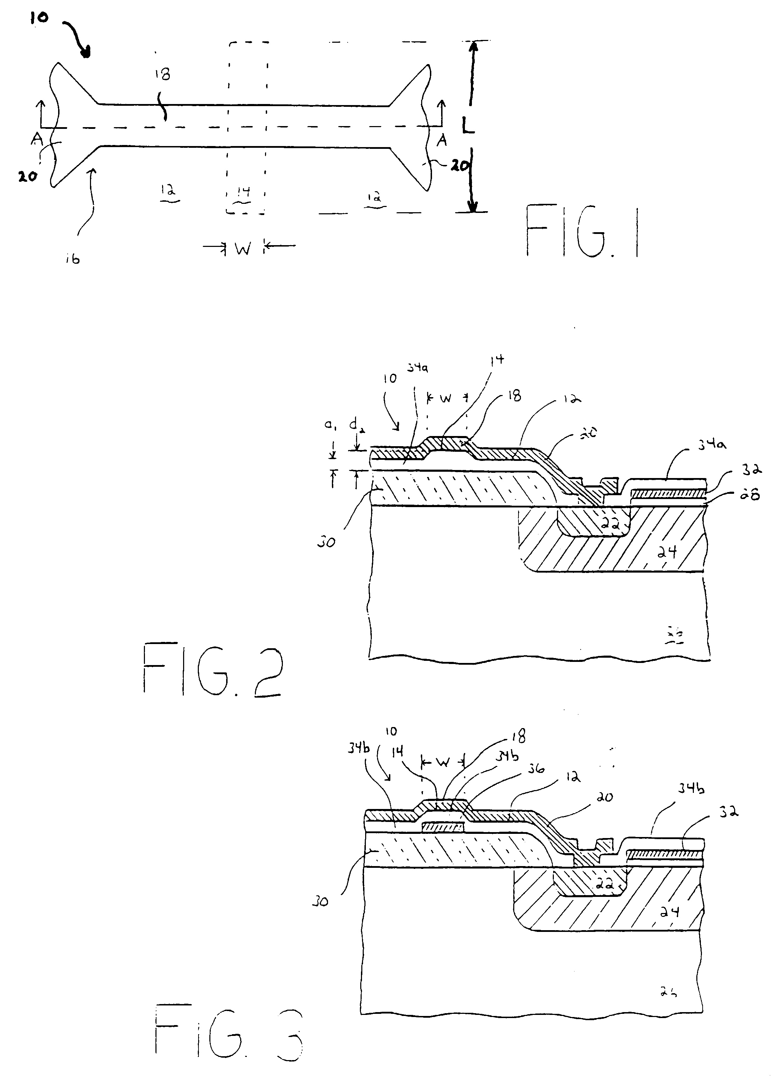

Referring to the drawings, Fig. 1 illustrates a fuse structure 10 placed across select areas of a semiconductor body topography. The semiconductor body can be lightly doped either N-type or P-type and can receive various diffusion regions of heavier dopant to form, for example, field effect transistors (FETs). Arranged at the upper surface of the semiconductor body is an insulating layer, wherein the layer includes a first upper surface 12 and a second upper surface 14. A metallization layer is placed across first and second upper surfaces 12 and 14, and then etched using standard wafer processing techniques. After it has been etched, the metallization layer is formed into an elongated conductor 16. A suitable deposition of the metallization layer can occur using conventional evaporation, sputtering, chemical vapor deposition (CVD), or electroplating techniques. The resulting thin film metallization can be etched using aqueous-based etches or by plasma etching. Preferably, conductor 16 is made of aluminum, wherein the metallization is formed using an aluminum-based sputter target and the etch can be either wet (strong acid or base such as NH₃PO₄) or dry (chlorine gas such as CF₄).

Conductor 16 includes an elongated filament 18 coupled between two ends of an interconnect 20. Filament 18 and interconnect 20 are fabricated as a unibody conductive structure (or conductor 16) from the metallization layer according to standard photolithography techniques known to those skilled in the art and described above. By applying a program current through filament 18 and/or a program voltage across filament 18, filament 18 will "blow" or separate at its weakest point (i.e., the point in which current density is maximum). A suitable programming current for a filament of two micrometer width and 11 micrometer length is approximately four to seven volts. The programming current is chosen assuming filament 18 is made of aluminum or aluminum alloy. It is appreciated that filament can be made of other types of material, however, aluminum is chosen for its high conductivity and ease of application within the normal processing flow of an integrated circuit.

Filament 18 will blow apart when programmed in the high current density areas where filament 18 is thinnest. By design, the thinner areas are those areas of the filament which extend from first upper surface 12 to second upper surface 14 and vice versa. Thin step coverage areas commonly exists in semiconductor fabrication whenever metallization is routed over a somewhat steep underlayer -- often caused by the routing of metallization over a new, thick underlayer outer perimeter or a rapid change in thickness of the underlayer. Where filament 18 extends from first surface 12 to second surface 14, a step region is formed of thin cross-section within filament 18 causing a higher current density in the thin step area. Likewise, when filament 18 extends from an upper surface 14 to a lower surface 12, a thin cross-section will exist. Accordingly, a preferred outcome of filament 18 routing is the separation of the filament into two ends at the thin juncture between first upper surface 12 and second upper surface 14.

Referring now to Fig. 2, a cross-sectional view of fuse structure 10 is shown having one end of interconnect 20 coupled to a diffusion region 22. Diffusion 22 is any active region such as, for example, a source or drain of an MOS transistor, or an emitter or collector of a TTL transistor. Diffusion 22 provides an area which can be electrically programmed and can store a one or zero logic level depending upon the configuration of fuse structure 10. Diffusion 22 can be arranged within a diffusion tub 24 (as shown) to form a CMOS embodiment. Alternatively, diffusion 22 can be placed directly into the bulk substrate 26. Diffusion region is doped dissimilar from the tub (or substrate) into which it is placed in order to form a transistor with an enhancement or depletion region between pairs of diffusions. Diffusion region can also be doped similar to the tub or substrate in order to make good electrical contact between the diffusion and substrate.

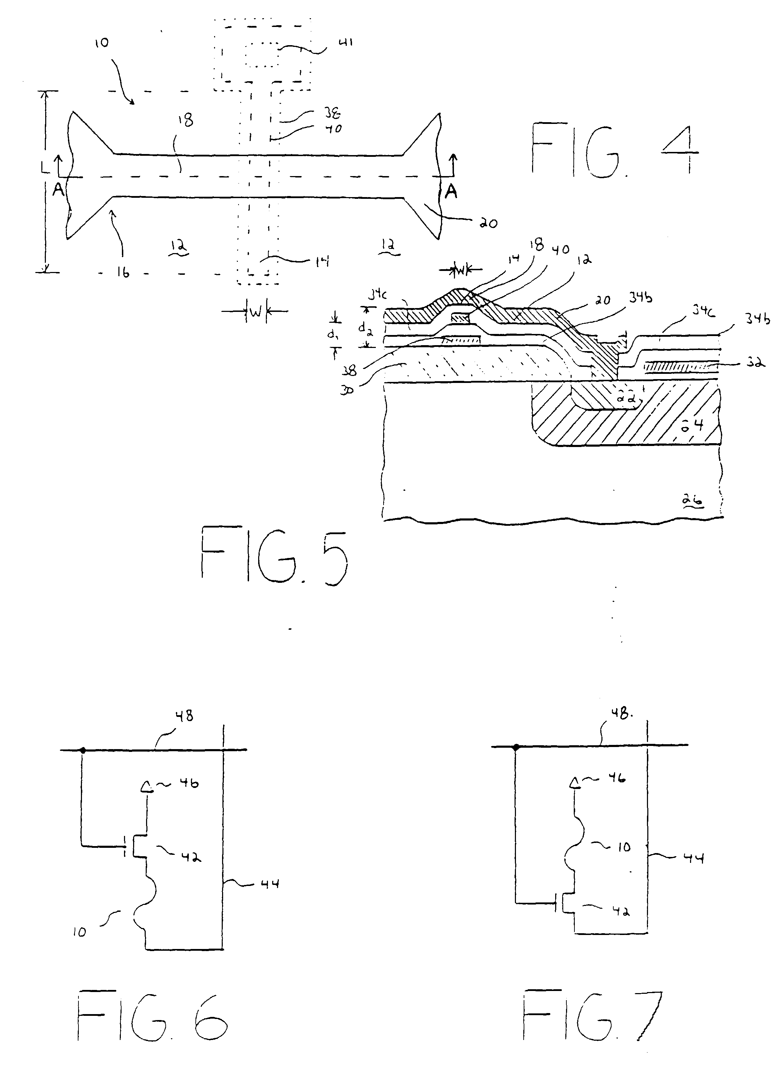

Substrate 26 includes an upper surface topography upon which various thin oxides 28 and thick oxides 30 can be placed. As defined herein, substrate includes the bulk material and any oxides which may happen to grow upon the bulk material thereby presenting a substrate topography receptive to insulating layers 34a, 34b or 34c. Oxides 28 and 30 are formed according to conventional thermal oxidation processes well known in the art. For example, if a silicon substrate is provided, oxides 28 and 30 are formed in the presence of oxygen to form SiO₂. The upper surface of oxide 28 can accommodate polycrystalline silicon 32 (or polysilicon) using conventional self-aligned processes. Thick oxide 30 can accommodate further organic, inorganic, conductive or insulative layers. Shown in Fig. 2 is an insulating layer 34a, possibly SiO₂, SiN, or phosphosilicate glass (PSG) placed over select portions of substrate 26 (comprising oxide 30). Accordingly, insulating layer 34a can be made of any insulating-type material and can be formed having different thickness. Insulating layer 34a includes a first upper surface 12 which extends a first distance d₁, or at least a first distance d₁, perpendicular to and above the upper surface of substrate 12 or oxide 30. Insulating layer 34a also includes a second upper surface 14 which extends a second distance d₂, or at least a second distance d₂, perpendicular to and above the upper surface of substrate 12 or oxide 30. The insulating layer is either (i) thickened as shown in Fig. 2 as reference numeral 34a, or (ii) raised over lower interconnect layers as shown in Fig. 3 as reference numeral 34b. The thickened layer 34a can be formed by using a series of masking and photolithography steps. For example, insulating layer 34a can be made very thick -- a thickness of approximately d₂. Thereafter, a mask is used to protect the second upper surface while allowing the remaining surface of layer 34a to be etched away to a second thickness of d₁. Using a series of masks allows for thick and thin regions for layer 34a.

Distances d₁ and d₂ can vary depending upon the amount of step severity needed to produce thin step coverage at the interface region. Preferably, distance d₁ includes any thickness necessary to achieve insulation between interconnect 18 and any underlying active diffusions. Distance d₂ is any thickness which ensures that an adequate protrusion or raised area exists.

Change in thickness of insulating layer 34 at the interface region between first and second upper surfaces 12 and 14 provides many advantages in the operation of fuse structure 10. First, change in thickness ensures a higher current density and that filament 18 is blown in the interface region. Second, when filament 18 is blown, the particles tend to project perpendicular to the sloped sidewalls of the thickened area and therefore away from the blown area. Due to the sloped sidewall underlayer, ejected particles tend to become expelled lateral to the upper surfaces and do not fall back into the filament-voided area. Third, after filament 18 is blown, the separated ends of the resulting filament 18 generally reside at the boundary between the first and second upper surfaces. The filament ends cannot easily reconnect since it is difficult for one end to electromigrate upward from the lower first surface to the higher second surface.

Referring to Figs. 1 and 2, the area of second upper surface is the area which resides at or exceeds second distance d₂ above the underlying substrate topography (which includes oxide 30). Second upper surface area has a width W and length L. Preferably, the area is rectangular or elongated in shape where length L is perpendicular to the direction in which filament 18 extends. Moreover, length L exceeds the width of filament 18 such that an overlap occurs. A suitable overlap beyond which second upper surface 14 extends perpendicular from the lateral sides of filament 18 is at least one micrometer. A suitable width W of second upper surface 14 is generally more than one micrometer and can be several micrometers. Careful geometric configuration of second upper surface 14 allows filament 18 to extend across at least a portion of width W of second upper surface 14. Preferably, filament 18 extends perpendicular to length L in order that, when programmed, filament 18 is severed perpendicular to its elongated axis and across the entire filament width.

Referring to Figs. 1 and 3, second upper surface 14 can be formed as a raised insulating layer 34b which is placed over a metallization region 36 to form a raised insulating area over which filament 18 is placed. Metallization layer 36 can be, for example, polysilicon. Polysilicon 36 can be formed in the same photolithography step as used to produce polysilicon gate layer 32. As such, the formation of raised insulating layer 34b can easily be accomplished using pre-existing processing steps. An additional step or steps are not needed to form second upper surface 14 from first upper surface 12 when a routing layer such as polysilicon underlayer is used to form the raised area. However, if insulating layer is thickened to form layer 34b, as shown in Fig. 2, then additional processing steps may be needed as described above. Polysilicon layer 36 can be one of numerous layers of polysilicon used to provide necessary interconnection. Thus, formation of second upper surface 14 occurs whenever insulating layer 34b is placed over an undercrossing polysilicon layer 36. By using a polysilicon layer 36 (or possibly a metal conductive layer), higher circuit density is allowed while achieving the raised underlayer.

Turning now to Fig. 4, a top plan view of a fuse structure is shown according to the present invention. In particular, fuse structure 10 utilizes two layers placed below and insulated from filament 18. Each layer is insulated from each other (shown in Fig. 5). The two layers can be metal conductors or polysilicon conductors or a combination of each. One layer is placed below the other layer and is denoted as first underlayer 38. First underlayer is wider and longer than second underlayer 40. Second underlayer 40 is placed above first underlayer 38, wherein both first and second underlayers 38 and 40, respectively, provide an insulating layer 34c placed immediately beneath conductor 18. Insulating layer 34c includes an upper surface or second upper surface 14. Second upper surface has a width W and a length L. Length L extends perpendicular to the elongated axis of filament 18 and is larger than the width of filament 18. Moreover, filament 18 extends across at least a portion of width W, and preferably extends across the entire width W. As shown, first underlayer 38 is connected via a contact 41 to second underlayer 40. Contact 41 is necessary to ensure physical stability and contact between first and second underlayer and that electrical connection can be ensured therebetween.

Referring to Figs. 4 and 5, second upper surface denotes a portion of the upper surface of insulating layer 34c. Insulating layer 34c is placed across the top and surrounding second underlayer 40, and second underlayer 40 is placed on the top of another insulating layer 34b. Insulating layer 34b is placed across the top and surrounds the upper and lateral sides of first underlayer 38. First upper surface 12 extends a first distance d₁ perpendicular to and above the upper surface of substrate 12 (including oxide 30). Second upper surface extends a second distance d₂ perpendicular to and above the upper surface of substrate 12 (including oxide 30). Similar to distances d₁ and d₂ shown in Fig. 2, distances d₁ and d₂ of Fig. 5 can vary depending upon the amount and step severity needed to produce thin step coverage at the interface region, and also to produce sufficient barrier against electromigration regrowth. A suitable raised distance (i.e., d₂ - d₁) can be several micrometers.

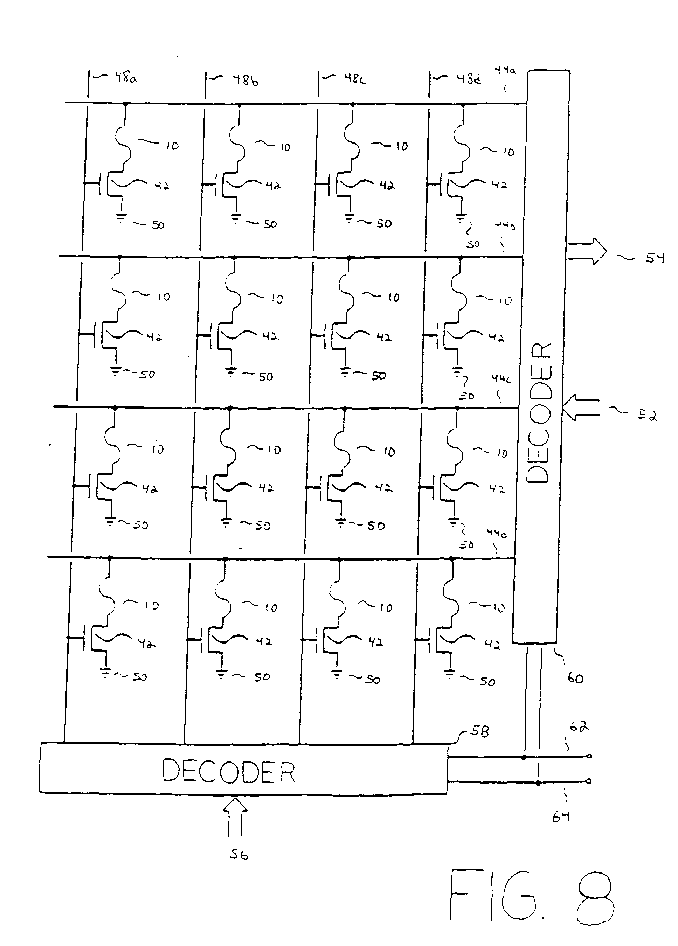

Referring to Figs. 6 and 7, alternative connection of fuse structure 10 is shown. Structure 10 can be used in a single transistor memory cell either coupled between bit line 44 and the drain of transistor 42 (see Fig. 6), or between power supply 46 and the source of transistor 42 (see Fig. 7). Placing a high level voltage upon word line 48 causes a conductive path to form between power supply 46 and bit line 44. If bit line 44 is maintained at a low logic level, then fuse 10 will blow. Subsequent addressing of word line 48 of a programmed fuse will read a floating voltage upon bit line 44. The floating voltage can represent a logic zero. If structure 10 is not programmed and bit line 48 is activated, then a logic one will be read upon bit line 44. Either embodiment of Fig. 6 or Fig. 7 will allow fuse 10 to be programmed and subsequently allow voltage to be stored in the diffusion region of source or drain to be read or addressed to bit line 44.

Referring to Fig. 8, a plurality of memory cells is shown placed within an array to form a programmable and addressable memory. Each memory cell can be similar to the cell shown in Fig. 6 or Fig. 7 or, alternatively, can be configured as shown in Fig. 8. Fuse structure 10 is placed between the drain of each transistor 42 and corresponding bit line 44a-d. A high voltage level upon a select word line (either word line 48a, b, c or d) and a high voltage level upon a select bit line (either bit line 44a, b, c or d) will cause corresponding fuse structure 10 to be blown open. After it is programmed, fuse structure 10 reads a floating voltage level when a corresponding cell is addressed.

A 4 x 4 array of memory cells shown in Fig. 8 represents only a small portion of numerous memory cells which can be arranged in an array to form a memory structure. A 4 x 4 array is chosen for simplicity. Each transistor 42 is preferably an n-channel transistor when coupled in a programmable array. Each transistor is connected in series with fuse structure 10 between bit lines and ground supply 50. When one word line (either 48a, b, c or d) is activated, a unique combination of data upon bit address input lines 52 will connect one bit line of the chosen word line to output 54. The particular word line chosen is addressed via input line 56. Accordingly, words lines are addressed by decoder 58, and bit lines are addressed by decoder 60.

To program any one of the memory cells in the array of Fig. 8, the word line associated with the memory is brought to the programming voltage, Vp. Vp is applied to both decoders by line 62. Vp voltage on line 62 will only be applied through decoders 58 and 60 when the signal on VGM line 64 is active. It is well known to those of skill in the art that decoders 58 and 60 are capable of handling Vp voltages and are activated upon receiving VGM signals.

It will be appreciated to those skilled in the art having the benefit of this disclosure that this invention is believed to be capable of numerous applications including a means for programming a memory array, coupling select circuits, and/or providing hardware or software programming of a generic circuit in the field to produce a user-specific application circuit. Various modifications and changes may be made without departing from the scope of the invention as set forth in the claims.

## Claims

1. An electromigration-resistant, electrically programmable fuse structure (10) comprising:
an integrated circuit substrate (26, 30);
a first insulating layer (34c) placed across the upper surface of said substrate,
wherein said layer includes a first upper surface (12) extending a first distance above the upper surface of said substrate, and a second upper surface (14) extending a second distance above the upper surface of said substrate, said first distance being less than said second distance; and
an elongate conductor (16) placed across a portion of said first upper surface and said second upper surface, said conductor including a filament (18) of lesser width and length than the remainder of said conductor, and said filament extending from the first upper surface, over a step connecting the first to the second upper surface, to the second upper surface, across a part of the second upper surface and from the second upper surface, over a step connecting the second to the first upper surface, back to the first upper surface such that the filament is thinner at the points where it crosses the steps connecting the first and second upper surfaces,
*characterised in that*
said second upper surface (14) is located over a metallization region (38),
and in that the structure further comprises a metal or polysilicon conducting underlayer (40), placed above said metallization region (38) and below said first insulating layer (34c), spaced from said metallization region by a second insulating layer (34b), the underlayer being narrower and shorter than the metallization region and electrically connected to it.

2. A fuse structure as claimed in claim 1, wherein said first insulating layer (34c) comprises silicon dioxide.

3. A fuse structure as claimed in claim 1 or claim 2, wherein said second insulating layer (34b) comprises silicon dioxide.

4. A fuse structure as claimed in any one of claims 1 to 3, wherein said metallization region (38) comprises polycrystalline silicon.

5. A fuse structure as claimed in any one of claims 1 to 3, wherein said metallization region (38) comprises a metal.

6. A fuse structure as claimed in any preceding claim, wherein said second upper surface (14) is configured to extend a length L and a width W and said filament (18) extends across said width W substantially perpendicular to said length L.

7. A fuse structure as claimed in claim 6, wherein said filament (18) has a width less than length L.

8. A fuse structure as claimed in any preceding claim electrically connected to a diffusion region (22) within said integrated circuit.

9. A fuse structure as claimed in claim 8, wherein said diffusion region (22) comprises a source or drain region of a MOS transistor.

10. A fuse structure as claimed in claim 8, wherein said diffusion region (22) comprises an emitter or collector region of a bipolar transistor.

## Patentansprüche

1. Elektromigrationsresistente elektrisch programmierbare Schmelzsicherungsstruktur (10) mit:
einem IC-Substrat (26, 30);
einer ersten Isolierschicht (34c) über der Oberseite des Substrats, wobei die Schicht eine erste Oberseite (12), die sich über eine erste Strecke über der Oberseite des Substrats erstreckt, und eine zweite Oberseite (14) aufweist, die sich über eine zweite Strecke über der Oberseite des Substrats erstreckt, wobei die erste Strecke kürzer als die zweite Strecke ist; und
einem länglichen Leiter (16), der über einen Bereich der ersten Oberseite und der zweiten Oberseite angeordnet ist, wobei der Leiter ein Filament (18) aufweist, das schmaler und kürzer als der übrige Leiter ist, und wobei sich das Filament von der ersten Oberseite über eine die erste mit der zweiten Oberseite verbindende Stufe zur zweiten Oberseite, über einen Teil der zweiten Oberseite und von der zweiten Oberseite über eine die zweite mit der ersten Oberseite verbindende Stufe zurück zur ersten Oberseite erstreckt, derart, daß das Filament an den Stellen, an denen es die die erste und die zweite Oberseite verbindenden Stufen quert, dünner ist;
dadurch gekennzeichnet, daß
die zweite Oberseite (14) über einem Metallisierungsbereich (38) angeordnet ist,
und daß die Struktur ferner eine leitfähige Metall- oder Polysilizium-Unterschicht (40) aufweist, die über dem Metallisierungsbereich (38) und unter der ersten Isolierschicht (34c) angeordnet und von dem Metallisierungsbereich durch eine zweite Isolierschicht (34b) beabstandet ist, wobei die Unterschicht schmaler und kürzer als der Metallisierungsbereich und elektrisch mit diesem verbunden ist.

2. Schmelzsicherungsstruktur nach Anspruch 1, bei der die erste Isolierschicht (34c) Siliziumdioxid aufweist.

3. Schmelzsicherungsstruktur nach Anspruch 1 oder 2, bei der die zweite Isolierschicht (34b) Siliziumdioxid aufweist.

4. Schmelzsicherungsstruktur nach einem der Ansprüche 1 bis 3, bei der der Metallisierungsbereich (38) ein polykristallines Silizium aufiveist.

5. Schmelzsicherungsstruktur nach einem der Ansprüche 1 bis 3, bei der der Metallisierungsbereich (38) ein Metall aufweist.

6. Schmelzsicherungsstruktur nach einem der vorhergehenden Ansprüche, bei der die zweite Oberseite (14) derart ausgebildet ist, daß sie sich über eine Länge L und eine Breite W erstreckt, und daß sich das Filament (18) über die Breite W im wesentlichen senkrecht zur Länge L erstreckt.

7. Schmelzsicherungsstruktur nach Anspruch 6, bei der die Breite des Filaments (18) geringer als dic Länge L ist.

8. Schmelzsicherungsstruktur nach einem der vorhergehenden Ansprüche, die elektrisch mit einem Diffusionsbereich (22) innerhalb der integrierten Schaltung verbunden ist.

9. Schmelzsicherungsstruktur nach Anspruch 8, bei der der Diffusionsbereich (22) einen Source- oder Drainbereich eines MOS-Transistors umfaßt.

10. Schmelzsicherungsstruktur nach Anspruch 8, bei der der Diffusionsbereich (22) einen Emitter- oder Kollektorbereich eines Bipolartransistors umfaßt.

## Revendications

1. Structures fusibles électriquement programmables (10), résistant à l'électromigration et comportant :
- un substrat de circuit intégré (26, 30) ;
- une première couche isolante (34c) placée sur la surface supérieure dudit substrat, ladite couche comportant une première surface supérieure (12) s'étendant sur une première distance au-dessus de la surface supérieure dudit substrat, et une seconde surface supérieure (14) s'étendant sur une seconde distance au-dessus de la surface supérieure dudit substrat, ladite première distance étant inférieure à ladite seconde distance ; et
- un conducteur allongé (16) placé sur une partie de ladite première surface supérieure et de ladite seconde surface supérieure, ledit conducteur comprenant un filament (18) de largeur et de longueur inférieures à celles du restant dudit conducteur, ledit filament s'étendant à partir de la première surface supérieure, par-dessus une transition reliant la première à la seconde surface supérieure, sur une partie de la seconde surface supérieure et, à partir de la seconde surface supérieure, par-dessus une transition reliant la seconde à la première surface supérieure, en retour vers la première surface supérieure, de telle sorte que le filament soit plus mince aux points où il traverse les transitions reliant la première et la seconde surface supérieure,
**caractérisées en ce que** :
- ladite seconde surface supérieure (14) est située au-dessus d'une région de métallisation (38), et
- en ce que la structure comporte, en outre, une sous-couche conductrice de métal ou de silicium polycristallin (40), placée au-dessus de ladite région de métallisation (38) et au-dessous de ladite première couche d'isolation (34c), espacée de ladite région de métallisation par une seconde couche d'isolation (34b), la sous-couche étant plus étroite et plus courte que la région de métallisation et étant reliée électriquement à celle-ci.

2. Structure fusible selon la revendication 1, caractérisée en ce que ladite première couche d'isolation (34c) est constituée de dioxyde de silicium.

3. Structure fusible selon la revendication 1 ou la revendication 2, **caractérisée en ce que** ladite seconde couche d'isolation (34b) est constituée de dioxyde de silicium.

4. Structure fusible selon une quelconque des revendications 1 à 3, **caractérisée en ce que** ladite région de métallisation (38) est constituée de silicium polycristallin.

5. Structure fusible selon une quelconque des revendications 1 à 3, **caractérisée en ce que** ladite région de métallisation (38) est constituée d'un métal.

6. Structure fusible selon une quelconque des revendications précédentes, **caractérisée en ce que** ladite seconde surface supérieure (14) est configurée pour s'étendre sur une longueur L et une largeur W et ledit filament (18) s'étend sur ladite largeur W sensiblement perpendiculaire à ladite longueur L.

7. Structure fusible selon la revendication 6, **caractérisée en ce que** ledit filament (18) possède une largeur inférieure à la longueur L.

8. Structure fusible selon une quelconque des revendications précédentes, **caractérisée en ce qu**'elle est reliée électriquement à une région de diffusion (22) à l'intérieur dudit circuit intégré.

9. Structure fusible selon la revendication 8, **caractérisée en ce que** ladite région de diffusion (22) constitue la région source ou la région drain d'un transistor MOS.

10. Structure fusible selon la revendication 8, **caractérisée en ce que** ladite région de diffusion (22) constitue une région d'émetteur ou une région de collecteur d'un transistor bipolaire.
